# EUROPEAN PATENT APPLICATION

(11) **EP 1 643 813 A1**
(43) Date of publication of application: **05.04.2006**
(21) Application number: 04747258.4
(22) Date of filing: 02.07.2004
(51) Int. Cl.: H05B 33/26

(54) **ORGANIC ELECTROLUMINESCENT DISPLAY PANEL AND METHOD FOR MANUFACTURING SAME**

(30) Priority: 07.07.2003 JP 2003192892
(71) Applicant: Pioneer Corporation, Tokyo 153-8654 (JP)
(72) Inventor: NAGAYAMA, Kenichi, Pioneer Corporation, Tsurugashima-shi, Saitama 3502288 (JP); MIYAGUCHI, Satoshi, Pioneer Corporation, Tsurugashima-shi, Saitama 3502288 (JP)
(74) Representative: Neugebauer, Jürgen
(86) International application number: PCT/JP2004/009790
(87) International publication number: WO 2005/004550

(57) **Abstract**

An organic electroluminescence display panel comprises: a plurality of organic electroluminescence devices, each of which comprises first and second display electrodes and an organic functional layer sandwiched and stacked between the first and second display electrodes, the organic functional layer including at least a light emitting layer comprising a single organic compound layer; and a substrate supporting the plurality of organic electroluminescence devices. At least one of the first and second display electrodes comprises a common layer formed in common with the plurality of organic electroluminescence devices. The common layer comprises a low resistance region corresponding to the organic electroluminescence device and a high resistance region connected to the low resistance region and having a higher resistivity than the low resistance region.

## Description

### TECHNICAL FIELD

The present invention relates to an organic electroluminescence device (referred to below as an organic EL device) having one or more thin layers (referred to below as an organic functional layer) including a light emitting layer formed from an organic compound material that exhibits electroluminescence emitting light by current injection, and more particularly, to an organic electroluminescence display panel (referred to below as an organic EL display panel) in which a plurality of organic EL devices are formed on a substrate.

### BACKGROUND ART

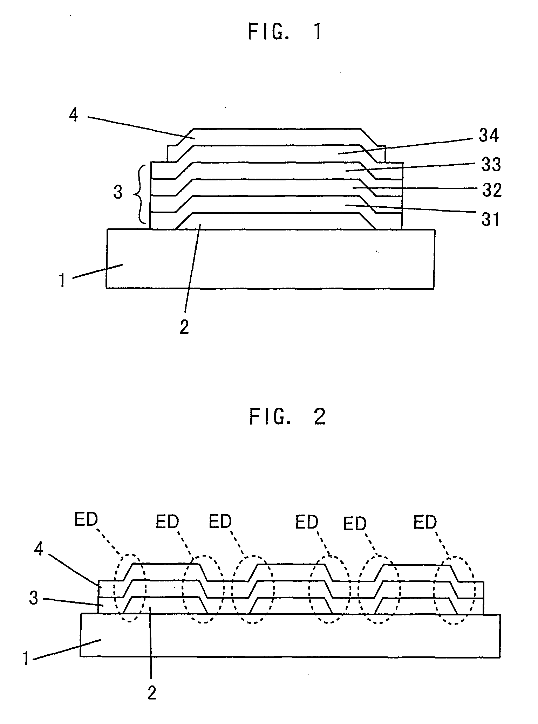

Organic EL devices have a basic structure in which an organic functional layer including a light emitting layer is sandwiched between display anode and cathode electrodes, and emit light when electrons and holes, injected as formed, from both electrodes are recombined and excitons return from an excited state to the ground state. As shown in Fig. 1, for example, the organic EL device comprises a transparent electrode 2 as an anode, an organic functional layer 3, and a metal electrode 4 as a cathode, all of which are sequentially stacked on a transparent substrate 1, and where light emission is obtained from the transparent substrate side. To permit light emission, at least one of the anode and cathode needs to be translucent or transparent. The organic functional layer 3 comprises a plurality of layers having each function and including, for example, a hole injection layer 31, a hole transport layer 32, a light emitting layer 33, and an electron transport layer 34, which are stacked up from the side of the transparent electrode 2.

Providing a plurality of such organic EL devices can create a complex display. A matrix type of organic EL display panel and a display having a predetermined light emission pattern are known examples.

By way of example, Fig. 2 illustrates a partial cross-sectional view of an organic EL display panel comprising a plurality of organic EL devices, in which first display electrodes 2 are disposed in parallel with each other (second display electrodes 4 are orthogonal to the plurality of first display electrodes 2). The film thickness of an organic functional layer 3, which is sandwiched between the first and second display electrodes 2 and 4 (referred to below simply as the first electrode and the second electrode, respectively), is generally extremely thin typically about 100 nm to 1 mm. Therefore, since an electric field gathers around the edges ED of the electrodes shown in Fig. 2, a dielectric breakdown occurs in the worst case, causing a short circuit between the first and second electrodes 2 and 4.

Methods to solve the short circuit problem are disclosed in, for example, Japanese Patent Laid-Open Publications Nos. 2002-25781 and 2002-246173 (referred to below as Patent Documents 1 and 2, respectively).

According to the technology described in the Patent Document 1, as shown in Fig. 3, an organic dielectric layer 5 is formed in the spaces between the first electrodes 2. If the edges of the first electrodes 2 are covered with the organic dielectric layer 5 in this fashion, a short circuit rarely occurs. Further, the Patent Document 1 points out a disadvantage of using a conventional polyimide film or the like, and proposes that the organic dielectric layer 5 is formed by a masked vapor deposition technique, the same formation method as the organic functional layer 3, whereby the first electrode 2, the organic dielectric layer 5, the organic functional layer 3, and the second electrode 4 are all fabricated in a continuous vacuum process without exposure to the atmosphere.

The Patent Document 2 discloses a method of preventing a short circuit by reducing the step between the first electrodes 1 in such a way that, using a resist pattern for patterning the first electrodes, the spaces between the first electrodes are filled with amorphous carbon or the like.

### DISCLOSURE OF THE INVENTION

As pointed out in the Patent Document 1, a problem with the structure of Fig. 2 is that a short circuit can occur at the edges ED of the first electrodes.

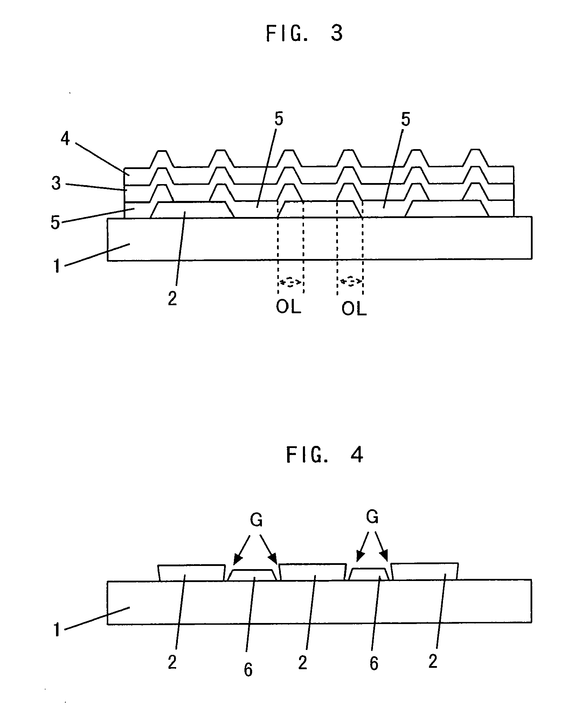

A problem with a structure having the organic dielectric layer 5 shown in Fig. 3 is, as pointed out in the Patent Document 1, that if polyimide is formed as a dielectric material by photolithograph, the process becomes complicated and also that a small quantity of moisture in the organic dielectric layers 5 can adversely affect the devices, causing dark spots to grow. Another problem is, as shown in Fig. 3, that the light emitting region is narrowed by the overlap region between the first electrode 2 and the organic dielectric layer 5, so that the aperture ratio is lowered and accordingly this makes it difficult to obtain a high-luminance display.

As proposed in the Patent Document 1, if the dielectric layer is formed in a continuous vacuum process without exposure to the atmosphere by masked vapor deposition as is the organic functional layer, it is possible to solve the problem of dark spots growing. However, in addition to forming the first electrode, the organic functional layer, and the second electrode, which are indispensable for an organic EL device, the dielectric layer must be formed from a different material. Therefore the problem remains that the process is complicated and the aperture ratio is lowered. The pattern formation method that can perform a continuous vacuum process without exposure to the atmosphere, such as masked vapor deposition or the like, is inferior in pattern accuracy to a formation method including a process performed outside of a vacuum, such as lithography or the like. Hence it has been difficult to obtain a high-resolution display with small pixels.

As proposed in the Patent Document 2, a method of filling the spaces between the first electrodes with amorphous carbon or the like is highly expected to have an effect of preventing a short circuit, on the condition that the top surfaces of both the first electrodes and filling films are formed flat so that they form substantially a plane. In practice, however, when the first electrodes are etched, side etching occurs, causing the widths of the first electrodes to be narrow. Therefore, as shown in Fig. 4, the gaps G tend to occur between the first electrodes 2 and the amorphous carbon films 6 filling therebetween. Further, since it is difficult to control the thickness of the filling amorphous carbon film 6 so as to be exactly identical to that of the first electrode 2, it is nearly impossible to completely eliminate the steps created by the first electrodes. These problems become increasingly pronounced, especially as the substrate becomes larger. Even if problems of, for example, the side etching and thickness control can be solved to obtain an ideal formation, the dielectric layer must be formed from amorphous carbon that is a different material, which introduces the same situation as in the Patent Document 1, so that the process becomes complicated.

Furthermore, with the structure described above, the first electrode patterns and the dielectric film patterns create steps, respectively, so that when the devices are sealed with a protection film, the film is incompletely formed at the steps. Therefore, this introduces risks which reduce the yield of fabricated devices or reduce the durability of the devices.

An object of the present invention is to provide an organic EL display panel that eliminates the steps at the edges of the electrodes of the organic EL devices and a method of fabricating the organic EL display panel.

An organic electroluminescence display panel as set forth in claim 1 comprises: a plurality of organic electroluminescence devices, each of which comprises first and second display electrodes and an organic functional layer sandwiched and stacked between the first and second display electrodes, including at least a light emitting layer comprising a single organic compound layer; and a substrate supporting the plurality of organic electroluminescence devices; wherein at least one of the first and second display electrodes comprises a common layer formed in common with the plurality of organic electroluminescence devices and the common layer comprises a low resistance region corresponding to the organic electroluminescence device and a high resistance region connected to the low resistance region and having a higher resistivity than the low resistance region.

A method of fabricating an organic electroluminescence display panel as set forth in claim 9 is one in which the organic electroluminescence display panel comprises a plurality of organic electroluminescence devices, each of which comprises first and second display electrodes and an organic functional layer sandwiched and stacked between the first and second display electrodes, including at least a light emitting layer comprising a single organic compound layer, and a substrate supporting the plurality of organic electroluminescence devices, the method comprising the steps of: forming a common layer having conductivity; and performing a resistance increasing process in which a high resistance region having a resistivity higher than the resistivity of the common layer is partially formed to define a low resistance region having a lower resistivity than the high resistance region, and the low resistance region is formed as at least one of the first and second display electrodes.

A method of fabricating an organic electroluminescence display panel as set forth in claim 13 is one in which the organic electroluminescence display panel comprises a plurality of organic electroluminescence devices, each of which comprises first and second display electrodes and an organic functional layer sandwiched and stacked between the first and second display electrodes, including at least a light emitting layer comprising a single organic compound layer, and a substrate supporting the plurality of organic electroluminescence devices, the method comprising the steps of: forming a common layer having a high resistance; and performing a resistance decreasing process in which a low resistance region having a resistivity lower than the resistivity of the common layer is partially formed to define a high resistance region having a higher resistivity than the low resistance region, and the low resistance region is formed as at least one of the first and second display electrodes.

A method of fabricating an organic electroluminescence display panel as set forth in claim 17 is one in which the organic electroluminescence display panel comprises a plurality of organic electroluminescence devices, each of which comprises first and second display electrodes and an organic functional layer sandwiched and stacked between the first and second display electrodes, including at least a light emitting layer comprising a single organic compound layer, and a substrate supporting the plurality of organic electroluminescence devices, the method comprising the steps of: forming a common layer having a high resistivity;
performing a resistance increasing process in which a high resistance region having a resistivity higher than the resistivity of the common layer is partially formed to define a low resistance region having a lower resistivity than the high resistance region; and
performing a resistance decreasing process in which a second low resistance region having a resistivity lower than the resistivity of the common layer is partially formed in the low resistance region, and the second low resistance region is formed as at least one of the first and second display electrodes.

### BRIEF DESCRIPTION OF THE DRAWINGS

Fig. 1 is a cross-sectional view schematically showing an organic EL device.
Figs. 2 and 3 are partial cross-sectional views each schematically showing an organic EL display panel.
Fig. 4 is a partial cross-sectional view schematically showing a part of an organic EL display panel in a fabrication process of the organic EL display panel.
Fig. 5 is a partial cross-sectional view schematically showing the organic EL display panel according to a first embodiment of the present invention.
Fig. 6 includes partial cross-sectional views schematically showing a part of an organic EL display panel in a fabrication process of the organic EL display panel according to an embodiment of the invention.
Figs. 7 through 10 include partial cross-sectional views schematically showing a part of an organic EL display panel in the fabrication processes of the organic EL display panel according to other embodiments of the invention.
Figs. 11 to 13 are partial cross-sectional views schematically showing organic EL display panels according to other embodiments of the invention.
Fig. 14 is a partial plan view schematically showing a part of an organic EL display panel in the fabrication process of the organic EL display panel according to still another embodiment of the invention.
Fig. 15 is a partial cross-sectional view schematically showing an organic EL display panel according to still another embodiment of the invention.

### DETAILED DESCRIPTION OF THE INVENTION

Embodiments will now be described with reference to the attached drawings.

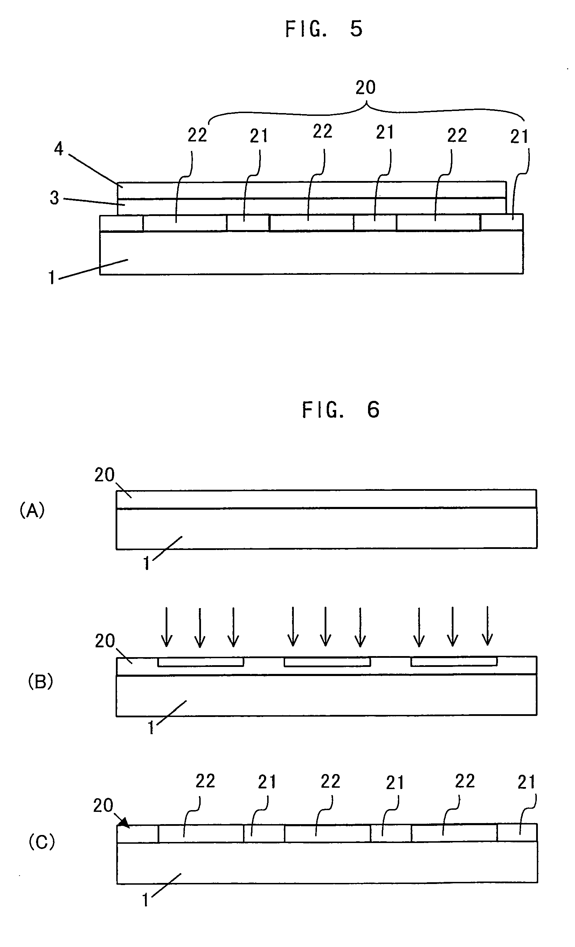

Fig. 5 is a schematic partial cross-sectional view showing a matrix type of organic EL display panel according to a first embodiment of the invention. As shown in Fig. 5, the organic EL display panel has a common layer 20 comprising a conductor or semiconductor formed on a transparent substrate 1 such as, for example, a glass or a plastic. The common layer 20 comprises high resistance regions 21 and low resistance regions 22 having a lower resistivity than the high resistance regions, wherein the low resistance regions 22 each function as a first electrode 22 and the high resistance regions 21 are connected to the low resistance regions 22 of the first electrodes so as to enclose them. Each organic EL device comprises the first electrode 22 of the low resistance region, an organic functional layer 3, and a second electrode 4, which are sequentially stacked, and a plurality of organic EL devices emit light from the side of the substrate 1.

Thus, in the first embodiment, the low resistance regions 22 having a low resistance and the high resistance regions 21 having a high resistance are provided in the common layer 20 formed on the substantially entire display surface of the substrate 1, wherein the low resistance region 22 is used as the first electrode 22 of the organic EL device. In the organic EL display panel structure shown in Fig. 5, the low resistance regions 22 and the high resistance regions 21 correspond to the conventional first electrode patterns and the spaces between the first electrodes, respectively. Further, light emission occurs only above the low resistance regions 22, and each low resistance region 22 operates independently as the first electrode.

Either one of the first and second electrodes 22 and 4 is used as an anode, and the other as a cathode. At least one of the first and second electrodes 22 and 4 needs to be transparent or translucent. Light emission can be observed from the side of the substrate when the first electrodes 22 are transparent and from the side of the film surface when the second electrodes 4 are transparent.

Known materials can be used for the first and second electrodes 22 and 4. For example, as a transparent electrode, ITO (indium tin oxide) or IZO (indium zinc oxide) can be used; as a translucent electrode, a very thin translucent film comprising a metal such as Al, Mg, Ag, Au, Pt, Pd, or Cr can be used; as an opaque electrode, a metal such as Al, Mg, Ag, Au, Pt, Pd, or Cr can be used. Using these materials, the electrode film is grown by, for example, a sputtering method, a vapor deposition method, or a CVD method.

As in Fig. 1, the organic functional layer comprises, for example, a hole injection layer, a hole transport layer, a light emitting layer, an electron transport layer, and an electron injection layer, for all of which known materials can be used as in the conventional organic EL device. The organic functional layer may also comprise: a single light emitting layer; a three-layer structure comprising an organic hole transport layer, a light emitting layer, and an organic electron transport layer; a two-layer structure comprising an organic hole transport layer and a light emitting layer; or a multi-layer structure in which an injection layer injecting electrons or holes and a carrier blocking layer are inserted between appropriate these layers. To form the organic functional layer, these materials are grown by, for example, a vapor deposition method or a spin coating method.

A sheet resistance of the low resistance regions 22 (first electrodes) in the common layer 20 is desirably low to reduce the voltage drop caused by the line resistance of a continuous electrode. It is desirable for the sheet resistance to be at least equal to 1 × 10⁶ Ω/□ or less, preferably equal to 1 × 10⁴ Ω/□ or less, and most preferably equal to 1 × 10² Ω/□ or less. In contrast, a resistance of the high resistance regions 21 (corresponding to the conventional spaces between the first electrodes) is desirably high to prevent electrical conduction between adjacent low resistance regions 22 (first electrodes). It is desirable for the resistance to be at least equal to 1 × 10⁶ Ω/□ or more, preferably equal to 1 × 10⁸ Ω/□ or more, and most preferably equal to 1 × 10¹⁰ Ω/□ or more.

The difference between the sheet resistances of the low and high resistance regions 22 and 21 is desirably large by at least two orders of magnitude, preferably by four orders of magnitude, and most preferably by six orders of magnitude or more.

The common layer 20 comprising the low resistance regions 22 and high resistance regions 21 is originally formed as a layer comprising an identical conductor or semiconductor, and then processed to decrease and/or increase the resistance of each region, thereby forming the low resistance regions 22 and high resistance regions 21. Specifically, for example, the following processes (1) to (3) are performed:

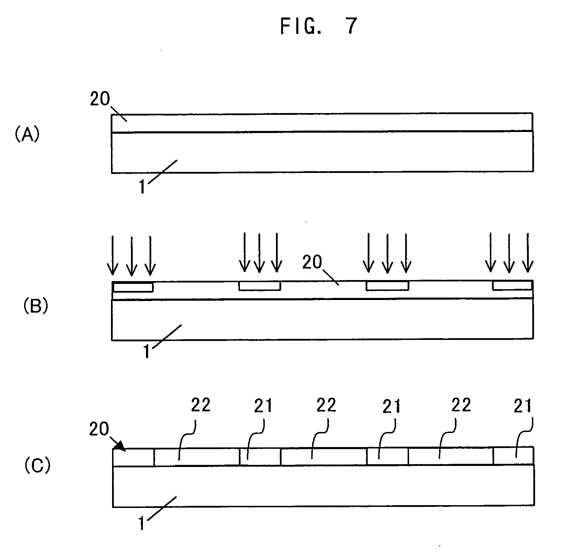

### (1) To partially perform a resistance decreasing process after forming a common layer having a high resistance (Fig. 6)

As shown in Fig. 6A, the common layer 20 comprising a conductor or semiconductor having a predetermined resistivity is formed on a substrate 1. Then, low resistance regions 22 having a resistivity lower than the predetermined resistivity of the common layer 20 are partially and gradually grown from the surface of the common layer 20 (Fig. 6B) to define high resistance regions 21 having a predetermined resistivity higher than that of the low resistance regions 22 (Fig. 6C: resistance decreasingprocess). The low resistance regions 22 are thus formed as the first electrodes.

### (2) To partially perform a resistance increasing process after forming a common layer having a low resistance (Fig. 7)

As shown in Fig. 7A, the common layer 20 comprising a conductor or semiconductor having a predetermined resistivity is formed on a substrate 1. Then, high resistance regions 21 having a resistivity higher than the predetermined resistivity of the common layer 20 are partially and gradually grown from the surface of the common layer 20 (Fig. 7B) to define low resistance regions 22 having a lower resistivity than the high resistance regions 21 (Fig. 7C: resistance increasing process). The low resistance regions 22 are thus formed as the first electrodes.

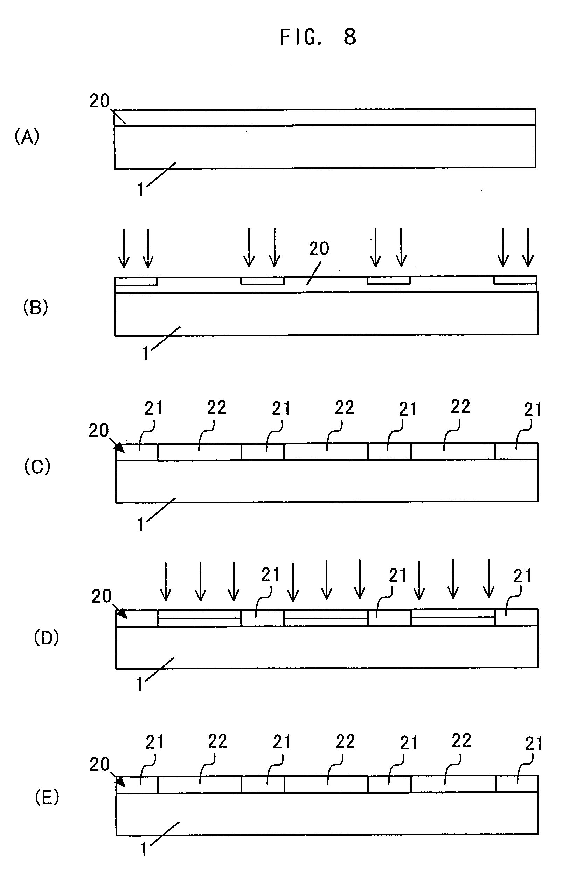

### (3) To perform each of the resistance decreasing and increasing processes after forming a common layer having a predetermined resistivity (Fig. 8)

As shown in Fig. 8A, the common layer 20 comprising a conductor or semiconductor having a predetermined resistivity is formed on a substrate 1.

As shown in Fig. 8B, high resistance regions 21 having a resistivity higher than the predetermined resistivity of the common layer 20 are partially and gradually grown (resistance increasing process), and, as shown in Fig. 8C, low resistance regions 22 having a lower resistivity than the high resistance regions 21 are defined.

As shown in Fig. 8D, in each low resistance region 22, second low resistance regions 22 having a resistivity lower than that of the common layer 20 is grown (resistance decreasing process), and, as shown in Fig. 8E, the second low resistance regions 22 are formed as the first electrodes.

In the processes shown in Fig. 8, the resistance increasing process is performed prior to the resistance decreasing process for convenience, but the resistance decreasing process may be performed first.

To divide the common layer 20 into the low and high resistance regions, for example, the following phenomena (1) to (3) can be used.

### (1) To use a chemical reaction

For example, after a low resistance material such as a metal or the like has been formed on the entire surface of a substrate as a common layer, a chemical treatment such as oxidation, nitridation, or sulfuration is partially performed on the areas where high resistance regions are to be formed, to produce oxide, nitride, or sulfide in the common layer, thereby forming the high resistance regions. Accordingly, the high resistance regions contain at least one of elements of sulfur, oxygen, and nitrogen, and has a higher content of at least one of elements of oxygen and nitrogen than the low resistance regions.

Alternatively, after a high resistance material such as a metal oxide or the like has been formed on the entire surface of a substrate as a common layer, a reduction reaction is partially performed on the areas where low resistance regions are to be formed, thereby forming the low resistance regions.

The low resistance regions and the high resistance regions thus contain an ingredient other than the common ingredient of a conductor or semiconductor, with a sufficient amount to produce the difference of their resistivities. That is, the low and high resistance regions contain main ingredients common to them.

### (2) To use a crystal structure change

Generally, if a crystal structure of a substance differs, its resistance also varies. As the structure changes from amorphous to a micro crystal, a small crystal and then a large crystal, the amount of presence of grain boundaries becomes smaller, causing the resistance of the substance to tend to be lower. It is also often the case that even the same crystal has a different resistance depending on a kind of the crystal.

The high resistance regions thus have an amorphous or poly-crystalline structure which has a larger amount of presence of grain boundaries than the low resistance regions.

### (3) To use the doping of donors or acceptors

It is generally known that doping a donor (n-type conduction) material or an acceptor (p-type conduction) material into a semiconductor can reduce its resistance. In contrast, compensating (undoping) the donors or acceptors already doped into a semiconductor can increase its resistance. The high resistance regions thus contain donors or acceptors, and are formed so as to have a smaller content of the donors or acceptors than the low resistance regions.

To decrease or increase the resistance using these phenomena, the following methods (1-a) to (3-b) can be cited as specific examples:

### (1 - a) Anodic oxidation method

In a solution such as, for example, boric acid-ammonium, applying an electric field to the regions in the common layer, which are exposed from a mask-protected substrate, can oxidize the regions contacting the solution. Metals such as, for example, Al, Mg, Ta, Ti, and Nb can be exemplified as those used for the common layer to which an anodic oxidation method can be applied.

### (1 - b) Heating in an atmosphere containing oxygen

If regions in the common layer formed of a material having alow resistivity, such as a metal, a transparent electrode material, or the like, are exposed from a mask-protected substrate and heated in an atmosphere containing oxygen, the regions contacting the oxygen are oxidized and becomes a high resistance. There are two heating methods: one is to heat the entire surface of the substrate by, for example, using a hot air circulation oven, a hot plate, an infrared heater, or irradiating laser beam on the entire surface of the substrate; the other is to partially heat the surface of the substrate by, for example, irradiating a focused laser beam.

Similarly, nitridation and sulfuration can also be performed by heating in an atmosphere containing nitrogen and sulfur, respectively.

### (1 - c) Irradiation of ion beam

Ionized oxygen is accelerated and injected into regions of the common layer formed of a material having a low resistivity such as a metal, a transparent electrode material, or the like, which are exposed from a mask-protected substrate, to oxidize the regions. The ion beams may be irradiated over the entire surface of the substrate by scanning, or may be selectively irradiated only on desired regions.

Similarly, nitridation and sulfuration can also be performed by ionizing nitrogen and sulfur for injection, respectively.

### (1 - d) Exposure to plasma

Plasma oxygen is contacted with regions in the common layer formed of a material having a low resistivity such as a metal, a transparent electrode material, or the like, which are exposed from a mask-protected substrate, to oxidize the regions.

Alternatively, plasma hydrogen is contacted with regions in the common layer to reduce the regions.

Similarly, using plasma nitrogen can nitride regions in the common layer.

### (2 - a) Annealing

A crystal structure is changed by heating or a cooling condition after heating. Partially irradiating a CW (continuous wave) laser on regions in the common layer, for example, can heat the irradiated regions and change their crystal structure.

### (3 - a) Ion implantation

A donor or acceptor material is ionized, and then its ion beam is generated, accelerated, and implanted, whereby the ions can be doped into regions in the common layer.

### (3 - b) Doping or undoping by a solution

It is known that organic materials such as polyaniline and the like change their resistances depending on how they are oxidized. When regions in the common layer formed of these materials, which are exposed from a mask-protected substrate, are dipped in an acid solution, the regions are doped with the acid, thereby reducing their resistances. In contrast, if the common layer with the doped regions is dipped in an alkaline solution (in some cases, the same effect can be obtained even by dipping in water), the acid is neutralized, thereby increasing the resistance of the regions.

Similarly, doping can also be carried out as in the ion doping by dipping in a solution containing a donor or acceptor element.

To fabricate an organic EL device of the invention, the common layer must be patterned or divided into high and low resistance regions. This patterning can be carried out by, for example, the following methods (A) and (B):

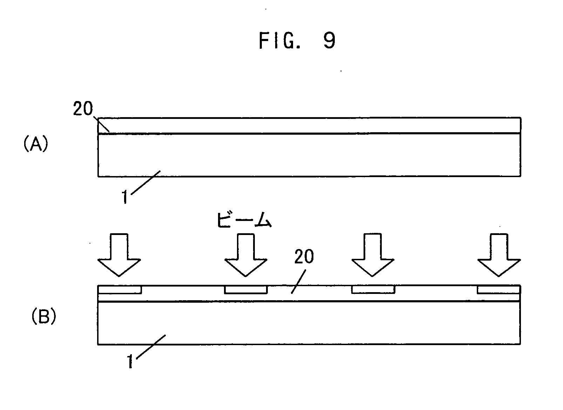

### (A) To partially perform a resistance increasing (decreasing) process (Fig. 9)

A common layer 20 comprising a conductor or semiconductor and having a predetermined resistivity is formed on a substrate 1 as shown in Fig. 9A, and a resistance increasing (decreasing) process is performed only on necessary regions. As shown in Fig. 9B, for example, focused laser beams are partially irradiated. With the above-described methods using laser beam, ion beam, and the like, since mostly narrow regions are processed and the relative position between the beam and the substrate can be changed, it is often the case that a high production efficiency is achieved. In addition, the process can be performed without forming a mask.

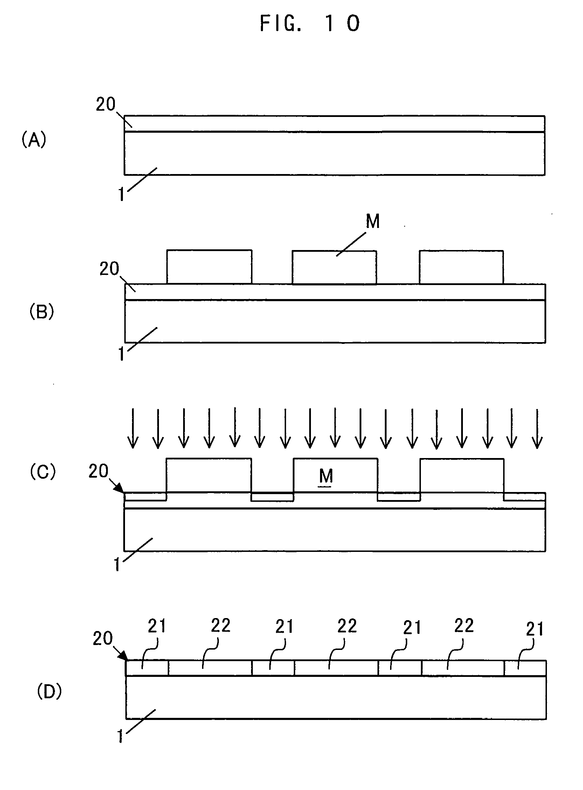

### (B) To perform a resistance increasing (decreasing) process on a substrate with a mask formed on a common layer (Fig. 10)

As shown in Fig. 10A, the common layer 20 comprising a conductor or semiconductor and having a predetermined resistivity is formed on the substrate 1. Subsequently, a mask M (for example, photoresist) is formed to mask the regions on which the process is not intended to be performed (Fig. 10B), and then the process is performed on the substantially entire surface of the substrate (Fig. 10C), after which the mask is removed (Fig. 10D). As a result, the process is performed only on the regions which have not been covered with the mask. If photoresist is used as a mask, fine patterning is possible.

### [Example 1]

An organic EL device of the invention was fabricated by the following procedure.

The coating liquid of a polyaniline derivative dissolved in an organic solvent and doped with an acid was spin-coated on a glass substrate. Subsequently, the substrate was heated using a hot plate, whereby the solvent was evaporated to form a common layer of a polyaniline film having a thickness of 100 nm on the substantially entire surface of the substrate. The measured sheet resistance of the polyaniline film was in the order of 1 × 105 Ω/□.

A mask pattern comprising two lines having a width of 2 mm and a line space of 1 mm was formed in a stripe shape on the common layer of the polyaniline film formed on the substrate, using the photoresist AZ6112 manufactured by TOKYO OHKA KOGYO CO., LTD.

In the above mask formation process, while the resist was developed in an alkaline developer solution such as a TMAH (tetramethyl ammonium hydroxide) aqueous solution or the like, the polyaniline film was undoped and changed color from green to blue at the opening (space) region (indicating the generation of a high line resistance region). That is, since the resistance increasing process was performed while forming the resist pattern, an additional resistance increasing process was not particularly required.

The measured sheet resistance of the high resistance region was in the order of 1 × 10¹⁰ Ω/□.

The photoresist mask was dissolved and removed by ethanol.

As an organic functional layer, an a-NPD film having a thickness of 70 nm and an Alq3 film having a thickness of 60 nm were formed on the polyaniline film substrate from which the mask had been removed, by a vapor deposition method with a metal mask.

Further, as a second electrode, an Al-Li alloy having a thickness of 100 nm and a width of 2 mm was formed to a single stripe shape (orthogonal to the high line resistance region) on the Alq3 film by a vapor deposition method with a metal mask, whereby the organic EL device of the invention was completed.

When a voltage of about 5 V was applied to the fabricated device with positive polarity at the first electrode and negative polarity at the second electrode, bright green light emission was observed. When an electrode terminal having positive polarity was alternately connected to two of the first electrodes, it was confirmed that each corresponding single pixel independently emitted light.

### [Example 2]

An organic EL device of the invention was fabricated by the following procedure.

As a common layer, an ITO film having a thickness of 150 nm was grown on a glass substrate by a sputtering method.

The measured sheet resistance of the common layer of the grown ITO film was 8 Ω/□.

A stripe-shaped mask pattern having 480 lines was formed on the common layer of the ITO film formed on the substrate, using the photoresist AZ6112 manufactured by TOKYO OHKA KOGYO CO. , LTD. The stripe photoresist mask had a line width of 120 mm and a line space of 10 mm (a pitch of 130 mm).

Ionized oxygen was accelerated and irradiated on the photoresist mask side of the substrate, and the oxygen ions were implanted through the mask openings (spaces) into the common layer of the ITO film.

The oxygen ions were thus implanted, enabling the sheet resistance of the oxygen ion-implanted regions of the ITO film (high line resistance regions) to be increased to the order of 1 × 1012 Ω/□.

The photoresist mask was dissolved and removed using acetone.

After cleaning the substrate from which the mask had been removed, an organic functional layer comprising an a-NPD film having a thickness of 70 nm and an Alq3 film having a thickness of 60 nm was formed on the common layer of the ITO film by a vapor deposition method with a metal mask.

Further, as second electrodes, an Al-Li alloy having a thickness of 100 nm, a line width of 250 mm, and a line space of 140 mm (a pitch of 390 mm) was formed in a stripe shape having 120 lines (orthogonal to the high line resistance regions) on the Alq3 film by a vapor deposition method with a metal mask.

Furthermore, as a protection film for protecting the device from moisture in the atmosphere, an SiON film having a thickness of 3 mm was formed on the second electrodes and Alq3 film (display area on the substrate) by a plasma CVD method, whereby the invented organic EL device comprising 480 × 120 pixels was completed. [Comparative Example 1]

A conventional organic EL device was fabricated in a manner such that the luminescence function layer, second electrodes, and protection film were formed in the same way as in the Example 1, except that the first electrodes were formed by the following procedure.

An ITO film having a thickness of 150 nm was grown on a glass substrate by a sputtering method.

A stripe-shaped mask pattern having 256 lines was formed on the ITO film formed on the substrate, using the photoresist AZ6112 manufactured by TOKYO OHKA KOGYO CO., LTD. The stripe photoresist mask had a line width of 120 mm and a line space of 10 mm (a pitch of 130 mm).

Such a substrate was dipped in a mixed solution of a ferric chloride aqueous solution and hydrochloric acid to etch the regions of the ITO film, which were not covered with the resist.

The photoresist mask was dissolved and removed by acetone to form the first electrodes.

### [Full lighting test of the panel]

The panels fabricated in the Example 2 and the Comparative Example 1 were connected to an appropriate driver circuit, and a continuous full lighting test was performed for an hour. After an hour, the observation of the light emitting conditions of each panel revealed that all pixels emitted light without problems in the panel fabricated in the Example 2, whereas 21 pixels had stopped emitting light in the panel fabricated in the Comparative Example 1. The observation of the pixels having stopped emitting light revealed that likely sources of short circuits between the first and second electrodes were observed at the edges of the ITO films.

It has been confirmed from this result that the Example 2 of the invention can fabricate an organic EL device with small defects caused by short circuits and substantially with the same process steps in comparison with the Comparative Example 1.

A planarization process of the first electrodes is more effective for preventing a short circuit. The planarization process includes, for example, mechanical polishing using an abrasive, chemical polishing using a chemical solution, and MCP (mechanical-chemical polishing) combining the two. The planarization process may be performed either before or after the resistance increasing (or decreasing) process. It is preferable, however, to perform the planarization process after the resistance increasing (or decreasing) process when the resistance increasing (or decreasing) process creates a volume change or thickness change so that the step differences between the low resistance regions and the high resistance regions occur with the order of 1 nm or more.

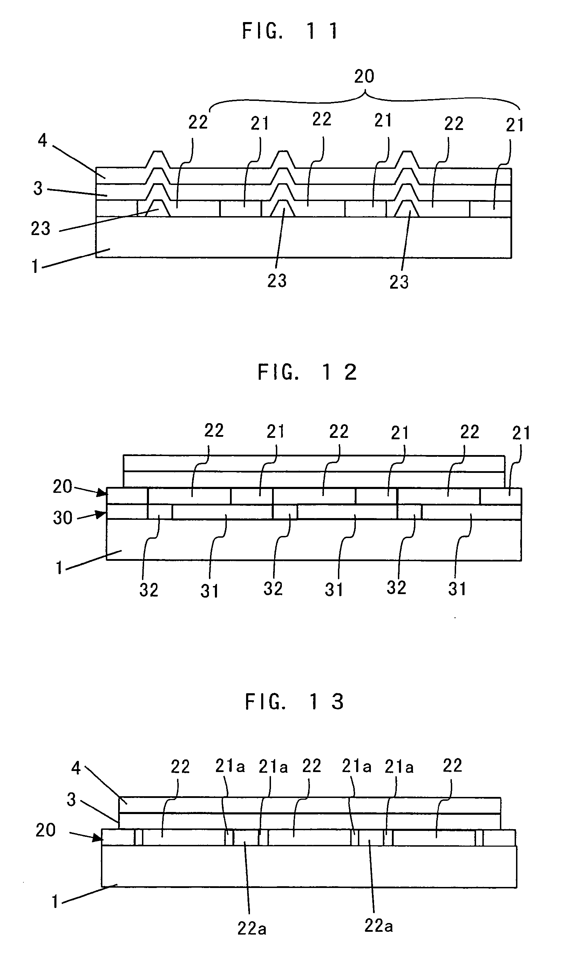

When the first electrodes have a high resistance, as shown in Fig. 11, auxiliary electrodes 23 may be formed in advance in the regions on a substrate 1 where low resistance regions 22 will be formed. As the auxiliary electrodes 23, a metal such as Al, Ag, Pt, Au, Pd, Cr, Ti, or Mo, or an alloy or multi-layer of these metals can be used. To prevent a short circuit, it is desirable that steps at the edges of the auxiliary electrodes 23 are as low and smooth as possible. For this purpose, the cross sections of the edges of the auxiliary electrodes 23 are formed to forward taper shapes and the common layer is formed by a film formation method having an excellent step coverage property, such as, for example, a sputtering method or a CVD method.

Alternatively, as shown in Fig. 12, auxiliary low resistance regions 32 may be previously formed in the regions on the substrate 1 where the low resistance regions 22 will be formed. For this purpose, an auxiliary common layer 30 is grown on the substrate 1 prior to the formation of the common layer 20, and then a resistance increasing (or decreasing) process is performed to form in advance auxiliary high resistance regions 31 and the auxiliary low resistance regions 32 so that they will be connected directly to below the high resistance regions 21 and low resistance regions 22. The auxiliary common layer 30 comprising the auxiliary high resistance regions 31 and the auxiliary low resistance regions 32 dissolves the problem caused by the steps at the edges.

Still alternatively, as shown in Fig. 13, when a space (high resistance region) between the low resistance regions 22 (first electrodes) is wide, it is not necessary to increase the resistance of the entire space region, but the resistance only on both side edges of the low resistance region 22 (first electrode) may be increased. That is, high resistance regions 21a having narrow widths, which are connected to the low resistance regions 22, and nonconnected low resistance regions 22a sandwiched between the high resistance regions 21a may be formed. When the first electrode pattern is formed by the above-described method in which a resistance increasing process is partially performed, this structure (in which the common layer 20 comprises the low resistance regions 22, high resistance regions 21a with narrow widths, and nonconnected low resistance regions 22a therebetween) is especially effective. That is because the structure shown in Fig. 13 has less regions on which the resistance increasing process is performed so that the time required for patterning can be reduced.

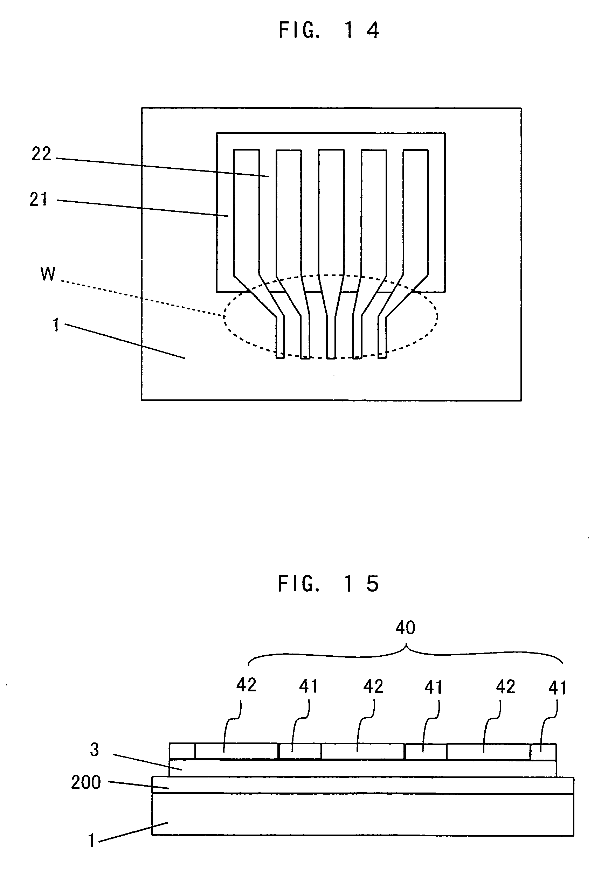

Still alternatively, as shown in Fig. 14, in an area other than the display area, for example, an interconnecting lead area W leading to outside, there is no risk of a short circuit. Therefore, the first electrode pattern may be conventionally formed to separate island shapes by, for example, an etching method. The common layer 20 on the substrate 1, comprising a conductor or semiconductor, includes a high resistance region 21 and low resistance regions 22 (first electrodes), wherein the high resistance region 21 is formed so as to enclose the low resistance regions 22 connected to the high resistance regions 21 and the low resistance regions 22 are connected to the interconnecting lead area W. In this case, the two processes, i.e., etching process of the first electrodes and resistance increasing (or decreasing) process, are necessary, but there are advantages that, for example, a dielectric film is not required and a short circuit is prevented.

Still alternatively, as shown in Fig. 15, the invention can also be applied to the second electrode. That is, the organic EL display panel comprises, for example, individual first electrodes 200, an organic functional layer 3, and a second common layer 40, all of which are sequentially stacked on a transparent substrate 1 such as a glass or a plastic, wherein the second common layer 40 comprises an identical conductor or semiconductor. The second common layer 40 comprises high resistance regions 41 and low resistance regions 42 having a lower resistivity than the high resistance regions, wherein the low resistance regions 42 function as second electrodes and the high resistance regions 41 are connected to the low resistance regions 42 so as to enclose them. In this case, there is a small effect on the prevention of a short circuit caused by the steps created by the first electrodes 200, but the steps created by the total thickness including the second common layer 40 are reduced so that there is an advantage that a smooth protection film can be formed later.

An example has been described above in which the invention is applied to an organic EL device, but it can also be applied to other devices having a similar structure such as, for example, inorganic EL devices. Further, in the above-described embodiments, an organic EL display panel of the simple matrix type has been described, but the invention can also be applied to an organic EL display panel of the active matrix type using, for example, TFTs (thin film transistors).

According to the present invention, an organic EL device can be fabricated with the substantially same number of process steps and less defects caused by short circuits in comparison with conventional methods. Specifically, according to the organic EL device of the invention, a short circuit is hardly to occur at the edges of the electrodes formed near the substrate.

Further, according to the invention, since a dielectric film used for the electrodes formed near the substrate can be eliminated, the process is facilitated, the dielectric film does not adversely affect the device, and the dark spots do not spread. In addition, the overlaps between the dielectric film and the electrodes formed near the substrate are not created, thereby obtaining a display having a high aperture ratio and a high luminance.

Furthermore, since the mask pattern of the electrodes formed near the substrate is formed with a good accuracy using lithography or other method, a display having small pixels and high fineness can be obtained.

Still furthermore, since electrodes formed near the substrate and a material filling the spaces therebetween are simultaneously formed, the process does not become complicated in comparison with the process described in the Patent Document 2 and also the steps created by these electrodes can be eliminated.

Still furthermore, since the steps created by the first electrode pattern, second electrode pattern, dielectric film pattern, and the like can be reduced when the device is sealed with a protection film, it is facilitated to form a smooth protection film with less roughness, thereby providing an device being fabricated with a high yield and having a high durability.

## Claims

1. An organic electroluminescence display panel comprising:
a plurality of organic electroluminescence devices, each of which comprises first and second display electrodes and an organic functional layer sandwiched and stacked between the first and second display electrodes, the organic functional layer including at least a light emitting layer comprising a single organic compound layer; and
a substrate supporting the plurality of organic electroluminescence devices,
wherein at least one of the first and second display electrodes comprises a common layer formed in common with the plurality of organic electroluminescence devices and the common layer comprises a low resistance region corresponding to the organic electroluminescence device and a high resistance region connected to the low resistance region and having a higher resistivity than the low resistance region.

2. The organic electroluminescence display panel according to claim 1, wherein the low resistance region has a sheet resistance of 1 × 10⁶ Ω/□ or less.

3. The organic electroluminescence display panel according to claim 1 or 2, wherein the high resistance region has a sheet resistance of 1 × 10⁶ Ω/□ or more.

4. The organic electroluminescence display panel according to claim 1, wherein the low resistance region and the high resistance region have a main ingredient common to each other.

5. The organic electroluminescence display panel according to any one of claims 1 to 3, wherein the difference in sheet resistance between the low resistance region and the high resistance region is equal to or greater than two orders of magnitude.

6. The organic electroluminescence display panel according to any one of claims 1 to 4, wherein the high resistance region contains at least one of oxygen and nitrogen as an added ingredient, and has a higher content of at least one of oxygen and nitrogen than the low resistance region.

7. The organic electroluminescence display panel according to any one of claims 1 to 4, wherein the high resistance region contains a donor or an acceptor and has a lower content of the donor or acceptor than the low resistance region.

8. The organic electroluminescence display panel according to any one of claims 1 to 4, wherein the high resistance region has an amorphous or polycrystalline structure, and contains a larger amount of presence of the grain boundaries in the crystalline structure than the low resistance region.

9. A method of fabricating an organic electroluminescence display panel, the organic electroluminescence display panel comprising: a plurality of organic electroluminescence devices, each of which comprises first and second display electrodes and an organic functional layer sandwiched and stacked between the first and second display electrodes, the organic functional layer including at least a light emitting layer comprising a single organic compound layer; and a substrate supporting the plurality of organic electroluminescence devices, the method comprising the steps of:
forming a common layer having conductivity; and
performing a resistance increasing process in which a high resistance region having a resistivity higher than the resistivity of the common layer is partially formed to define a low resistance region having a lower resistivity than the high resistance region, and the low resistance region is formed as at least one of the first and second display electrodes.

10. The fabricating method according to claim 9, wherein the resistance increasing process step comprises a process for partially oxidizing or nitriding the common layer by placing the substrate in an oxygen or nitrogen atmosphere.

11. The fabricating method according to claim 9, wherein the common layer contains a donor or an acceptor, and the resistance increasing process step comprises a process for partially undoping the donor or acceptor.

12. The fabricating method according to claim 9, wherein the common layer has an amorphous or polycrystalline structure, and the resistance increasing process step comprises a step of partially annealing the common layer, in which a process for increasing an amount of presence of the grain boundaries in the crystalline structure in comparison with the low resistance region is performed.

13. A method of fabricating an organic electroluminescence display panel, the organic electroluminescence display panel comprising: a plurality of organic electroluminescence devices, each of which comprises first and second display electrodes and an organic functional layer sandwiched and stacked between the first and second display electrodes, the organic functional layer including at least a light emitting layer comprising a single organic compound layer; and a substrate supporting the plurality of organic electroluminescence devices, the method comprising the steps of:
forming a common layer having a high resistance; and
performing a resistance decreasing process in which a low resistance region having a resistivity lower than the resistivity of the common layer is partially formed to define a high resistance region having a higher resistivity than the low resistance region, and the low resistance region is formed as at least one of the first and second display electrodes.

14. The fabricating method according to claim 13, wherein the resistance decreasing process step comprises a process for partially reducing the common layer by placing the substrate in a reduction atmosphere.

15. The fabricating method according to claim 13, wherein the resistance decreasing process step comprises a process for partially doping the donor or acceptor.

16. The fabricating method according to claim 13, wherein the common layer has an amorphous or polycrystalline structure, and the resistance decreasing process step comprises a step of partially annealing the common layer, in which a process for decreasing an amount of presence of the grain boundaries in the crystalline structure in comparison with the high resistance region is performed.

17. A method of fabricating an organic electroluminescence display panel, the organic electroluminescence display panel comprising: a plurality of organic electroluminescence devices, each of which comprises first and second display electrodes and an organic functional layer sandwiched and stacked between the first and second display electrodes, the organic functional layer including at least a light emitting layer comprising a single organic compound layer; and a substrate supporting the plurality of organic electroluminescence devices, the method comprising the steps of:
forming a common layer having conductivity;
performing a resistance increasing process in which a high resistance region having a resistivity higher than the resistivity of the common layer is partially formed to define a low resistance region having a lower resistivity than the high resistance region; and
performing a resistance decreasing process in which a second low resistance region having a resistivity lower than the resistivity of the common layer is partially formed in the low resistance region, and the second low resistance region is formed as at least one of the first and second display electrodes.

18. The fabricating method according to claim 17, wherein the resistance increasing process step comprises a process for partially oxidizing or nitriding the common layer by placing the substrate in an oxygen or nitrogen atmosphere.

19. The fabricating method according to claim 17, wherein the common layer contains a donor or an acceptor, and the resistance increasing process step comprises a process for partially undoping the donor or acceptor.

20. The fabricating method according to claim 17, wherein the common layer has an amorphous or polycrystalline structure, and the resistance increasing process step comprises a step of partially annealing the common layer in which a process for increasing an amount of presence of the grain boundaries in the crystalline structure in comparison with the low resistance region is performed.

21. The fabricating method according to claim 17, wherein the resistance decreasing process step comprises a process for partially reducing the common layer by placing the substrate in a reduction atmosphere.

22. The fabricating method according to claim 17, wherein the resistance decreasing process step comprises a process for partially doping the donor or acceptor.

23. The fabricating method according to claim 17, wherein the common layer has an amorphous or polycrystalline structure, and the resistance decreasing process step comprises a step of partially annealing the low resistance region in which a process for decreasing an amount of presence of the grain boundaries in the crystalline structure in comparison with the low resistance region is performed.
